# EUROPEAN PATENT APPLICATION

(11) **EP 0 719 079 A1**
(43) Date of publication of application: **26.06.1996**
(21) Application number: 95119116.2
(22) Date of filing: 05.12.1995
(51) Int. Cl.: H05K 1/16

(54) **Printed circuit board**

(30) Priority: 22.12.1994 JP 319628/94; 06.06.1995 JP 139003/95
(71) Applicant: KANTO KASEI CO., LTD., Yokosuka-shi Kanagawa-ken (JP)
(72) Inventor: Tsuchida, Akihito, Yokosuka, Kanagawa (JP); Sekino, Yoshito, Yokosuka, Kanagawa (JP)
(74) Representative: Schulze Horn, Stefan, Dipl.-Ing. M.Sc.

(57) **Abstract**

A resistor (5) is provided in a conductor layer (4) by being electrically connected thereto so that a surface of the resistor (5) and that of the conductor layer (4) is included in one plane in the direction of the thickness of a printed board (2) with the conductor layer (4) provided in a base (2') for a printed circuit.

## Description

### FIELD OF THE INVENTION

The present invention relates to a printed circuit board.

### BACKGROUND OF THE INVENTION

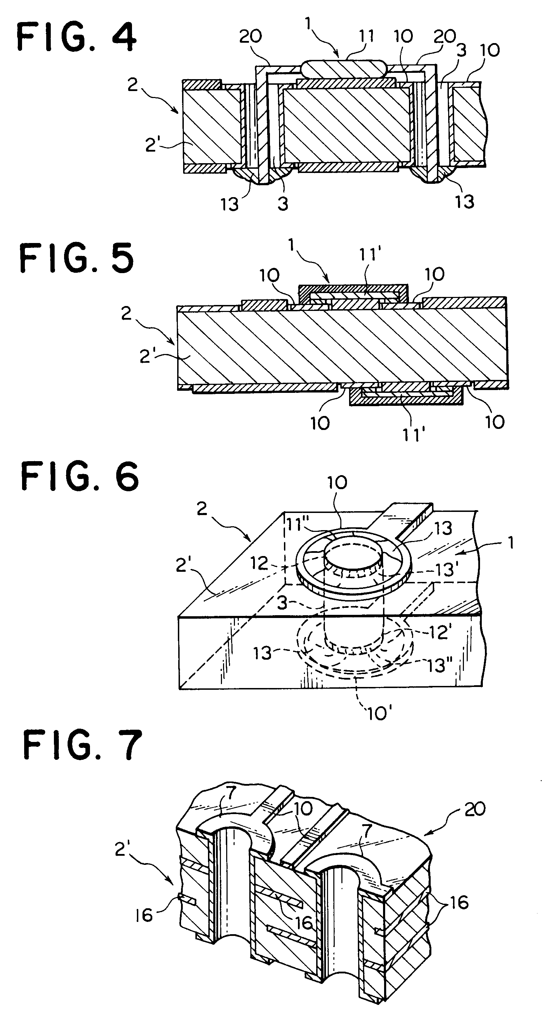

As conventional types of printed circuit board 1, there are some well known printed circuit boards in which, (1) as shown in Fig.4, a circuit is constructed by inserting a lead 20 of a resistor 11 to a hole 3 penetrating a land 10 of a printed board 2 having a base 2' for a printed circuit comprising an electrical insulating material such as glass epoxy and the land 10 of a conductor provided on the surface of the base, placing the resistor 11 on the printed board 2, and soldering 13 terminals of the lead 20 to the land 10, or as shown in Fig.5, by providing a chip resistor or printed resistors 11' between the lands 10 ,10 by means of printing to construct a circuit; and in which, (2) as disclosed in Japanese Patent Laid-Open Publication No.73501/1987, or as shown in Fig. 6, a circuit is constructed by providing therein a hole 3 penetrating a base 2' for a printed circuit and lands 10 and 10', preliminarily providing solder 13' , 13'' at both edges 12 and 12' of a solid resistor 11'' being slightly longer than a thickness of the printed board 2 including therein the lands 10 and 10' respectively, inserting them into the hole 3, and by soldering the both edges 12 and 12' thereof to the lands 10 and 10' respectively. It should be noted that, as shown in Fig.7, what is called the multilayer printed board 20 having an internal layer electrical wiring 16 formed with a conductive member in the internal layer other than a surface of the base 2' for a printed circuit having an electrical insulating capability may be used for a printed board.

In the printed circuit board (1) as described above, a resistor is placed on the printed board, and soldering the lead to the land is required, and in the printed circuit board (2) described above, the resistor embedded in the hole is formed slightly longer than a thickness of the printed board, and at the same time preliminarily soldering is required, which make a thickness of the printed circuit board larger in proportion to a thickness of solder, and furthermore the resistor is placed on the board, which generates unnecessary spaces therein, and for this reason size reduction and cost reduction thereof are hindered, and pollution due to lead may occur because of use of solder.

It is an object of the present invention to provide a printed circuit board enabling resolution of problems in the conventional type of printed circuit boards as described above, and also achievement of size reduction, cost reduction, and reduction of pollution by enhancing board density.

### SUMMARY OF THE INVENTION

The present invention was made in the light of the circumstances as described above, and in the invention as described in Claim 1, a resistor is provided in a conductor layer by being electrically connected thereto so that the surface of the resistor and that of the conductor layer are included in one plane in the direction of the thickness of the printed board in which the conductor layer is provided on a base for the printed circuit. In the invention as described in Claim 2, any diameter or any shape of a hole in which the resistor according to Claim 1 is to be provided is selected as necessary, so that a resistance value of the resistor will be set to a specified one. In the invention as described in Claim 3, any material for the resistor according to Claim 1 is selected as necessary, and a resistance value thereof will be set to a specified one. In the invention as described in Claim 4, the printed board according Claim 1 is a multilayer printed board having an electrical wiring in the internal layer thereof. In the invention as described in Claim 5, a plurality of printed circuit boards according to Claim 1 are laminated through insulation layers. In the invention as described in Claim 6, the printed circuit board according to Claim 1 or 5 is formed by means of the subtractive process or additive process.

As described above, in the invention as described in Claim 1, a circuit is formed by being conducted to a conductor layer by a resistor provided so that the surface of the resistor and that of the conductor layer of the printed board are included in one plane in the direction of the thickness of the printed board. In the invention as described in Claim 2, any diameter or any shape of the hole in which the resistor is to be provided is selected as necessary, and a specified resistance value of the resistor provided in the hole is obtained. In the invention as described in Claim 3, a certain material for the resistor is selected as necessary and a specified resistance value thereof is obtained. In the invention as described in Claim 4, the printed circuit board is formed by using the multilayer printed board having an electrical wiring in the internal layer thereof. In the invention as described in Claim 5, a circuit is formed by multilayering the printed circuit board through the insulation layer. In the invention as described in Claim 6, the printed circuit board is formed by the subtractive process or additive process.

### BRIEF DESCRIPTION OF THE DRAWINGS

Fig. 1 is a vertical cross-sectional view showing a key section of the printed circuit board according to Embodiment 1 of the present invention;
Fig. 2 is a vertical cross-sectional view showing a state where the resistor describe above is embedded according to Embodiment 1 of the present invention;
Fig. 3 is a vertical cross-sectional view showing a key section of printed circuit board according to Embodiment 3 of the present invention;
Fig. 4 is a vertical cross-sectional view showing a key section of a conventional type of the printed circuit board;
Fig. 5 is a vertical cross-sectional view showing a key section of another type of the printed circuit board described above;
Fig. 6 is a vertical cross-sectional view showing a key section of still another type of the printed circuit board as described above; and
Fig. 7 is a cross-sectional perspective view showing a multilayer printed circuit board.

### DETAILED DESCRIPTION OF THE PREFERRED EMBODIMENT

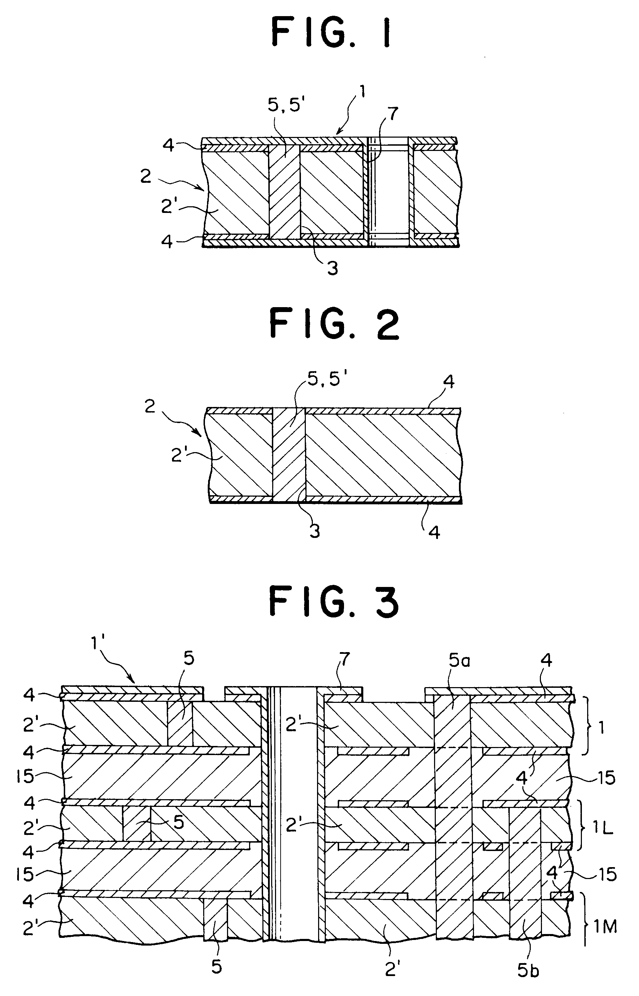

In the embodiments according to the present invention shown in Figs.1 to 3, the same reference numerals are assigned to the portions playing the same functions as those in the conventional types thereof described above, so that description thereof are omitted herein, and description is made mainly for different portions.

In Embodiment 1 according to the present invention as shown in Figs.1 and 2, a printed board 2 in which a conductor layer 4 to function as a land is provided only on the surface of a base 2' for the printed circuit is used, a hole for a resistor 5 penetrating the conductor layer 4 and the base 2' for the printed circuit in the direction of the thickness thereof is provided, carbon or a carbon-based resistor substance 5' is embedded into this hole 3 by using any of a press-fitting process, a sucking process, injecting process, or a combination thereof, the resistor substance is cured, the residual resistor substance protruding from the surface of the conductor layer 4 is cut off or removed by buffing so that the surface of the resistor and that of the conductor layer 4 are included in one plane surface, to form the resistor substance into a resistor, and thus the printed circuit board 1 as shown in Fig.1 is formed by means of the subtractive process or the additive process conventionally used. It should be noted that the printed circuit board 1 may be formed by means of the subtractive process or the additive process by using a base 2' for the printed circuit without a conductor layer 4 to be provided therein in place of the printed board 2.

In the printed circuit board described above, there is electrical continuity between the resistor 5 and the conductor layer 4, and the circuit is formed according to the circuit pattern.

Also, to obtain a desired resistance value of the resistor 5, any diameter of this hole 3 should be selected as necessary, and this hole 3 is formed by means of drilling, press working, or laser beam machining, and the shape thereof is not necessarily required to be a circle, and may be a triangle, or a square or any of other shapes, and furthermore, a desired resistance value may be obtained by selecting a certain material for the resistor substance 5' as necessary.

As described above, the resistor 5 having a desired resistance value in the direction of the thickness of the printed circuit board 2 is included in the printed board 2 so that the surface of the resistor does not come out of the surface of the printed board 2, and a surface of the printed circuit board 2 does not have any specific space where placement of any component is inhibited such as so-called the mounting-inhibited area, nor a bottom surface of IC or the like or any other specific space as that in the conventional technology, so that a resistor can be mounted in an area in which placement of component has been impossible in the conventional technology, and at the same time other components can be superimposed on and attached to a top section of mounted resistor 5, which makes it possible to build-up components, and for this reason size reduction and cost reduction can be achieved by improving the board density. Furthermore, soldering to a mounted resistor 5 is not required, so that pollution due to lead can be reduced.

In Embodiment 2, a printed circuit board is formed by using the multilayer printed board 20 shown in Fig.7 in place of the printed board used in Embodiment 1, and subjecting this multilayer printed board 20 to the same processing as that in Embodiment 1, then embedding the resistor thereinto. In the board as described above, a jumper circuit across circuits can easily be formed, which makes an occupied area of the circuit smaller.

In Embodiment 3, as shown in Fig.3, a plurality of the printed circuit board 1 according to Embodiment 1 are laminated through insulation layers 15. A multilayer printed circuit board 1' is formed by using an epoxy-based material having an insulating capability as an insulation layer 15, and sandwiching this member between the printed circuit boards 1, and heat-welding them to each other. An epoxy-based material may not necessarily be used for this insulation layer 15, and other appropriate member having an insulating capability may be used in place thereof. In a case where conductor layers in the printed circuit boards in the multilayer printed circuit board 1' are expected to be electrically connected to each other, a hole is made in the portion and through-hole plating 7 is applied thereto. In the circuit board, a three-dimensional circuits can be formed, which makes an occupied area thereof smaller. It should be noted that, the printed circuit board in Embodiment 2 may be used as a multilayer printed circuit board in place of the printed circuit board in Embodiment 1. Also resistors 5a and 5b may be provided, like in Embodiment 1, between each layer of a plurality sheets of printed circuit boards, or between desired several sheets of the printed circuit boards 1_{L} and 1_{M} in this multilayer printed circuit board. Then the printed circuit board 1 is formed by the subtractive process or an additive process.

The present invention is as described above, and in the invention as described in Claim 1, a resistor is provided in the conductor layer by being electrically connected thereto so that the surface of the resistor and that of the conductor layer in the direction of the thickness of the printed board with a conductor layer provided in a base for the printed circuit are included in one plane, which makes it possible to achieve high-board density, size reduction, cost reduction, and pollution-free thereof. In the invention as described in Claim 2, any diameter or any shape of a hole in which the resister according to Claim 1 is to be provided is selected as necessary and a resistance value of the resistor is set to a specified one, and in the invention as described in Claim 3, any material of the resistor according to Claim 1 is selected as necessary and a resistance value of the resistor is set to a specified one, so that a low-cost circuit having a desired resistance value can be obtained. In the invention as described in Claim 4, the printed board according to Claim 1 is a multilayer printed board having an electrical wiring in the internal section thereof, so that the electrical wiring can be made three-dimensionally, which makes an occupied area of a circuit smaller, and also makes it possible to achieve high-board density, size reduction, cost reduction, and reduction of pollution. In the invention as described in Claim 5, a plurality of the printed circuit boards according to Claim 1 are laminated through insulation layers, which makes an occupied area of a circuit smaller, and makes it possible to achieve high-board density, size reduction, cost reduction, and reduction of pollution. In the invention as described in Claim 6, the printed circuit board according to Claim 1 or 5 is formed by the subtracted process or the additive process, which makes it possible to achieve high-board density, size reduction, cost-reduction, and reduction of pollution.

## Claims

1. A printed circuit board, wherein a resistor is provided in a conductor layer by being electrically connected thereto so that a surface of said resistor and a surface of said conductor layer are included in one plane in the direction of the thickness of a printed board with said conductor layer provided in a base for a printed circuit.

2. A printed circuit board, wherein any diameter or any shape of a hole in which said resistor according to Claim 1 to be provided is selected as necessary, and a resistance value of said resistor is set to a specified one.

3. A printed circuit board, wherein any material of said resistor according to Claim 1 is selected as necessary, and a resistance value of said resistor is set to a specified one.

4. A printed circuit board, wherein said printed board according to Claim 1 is a multilayer printed board having an electrical wiring in an internal layer thereof.

5. A printed circuit board, wherein a plurality of said printed circuit boards according to Claim 1 are laminated through insulation layers.

6. A printed circuit board, wherein said printed circuit board according to Claim 1 or 5 is formed by the subtractive process or additive process.
